# EUROPEAN PATENT APPLICATION

(11) **EP 4 492 076 A1**
(43) Date of publication of application: **15.01.2025**
(21) Application number: 23306209.0
(22) Date of filing: 13.07.2023
(51) Int. Cl.: G01R 31/396, H01M 10/42, H02J 7/00

(54) **BATTERY MANAGEMENT UNIT**

(71) Applicant: NXP USA, Inc., Austin TX 78735 (US)
(72) Inventor: Perruchoud, Philippe Jean-Pierre, Toulouse (FR); Rousseille, Philippe, Toulouse (FR); Panis, Guerric, Toulouse (FR); Huot-Marchand, Alexis Nathanael, Toulouse (FR)
(74) Representative: Schmütz, Christian Klaus Johannes

(57) **Abstract**

A battery management unit, BMU, configured to communicate, in parallel, with a plurality of cell monitoring circuits, CMCs, configured to provide for monitoring of battery cells and store a chain-identifier parameter initially comprising a predetermined default value, wherein the BMU is configured to perform a chain-identifier parameter assignment procedure comprising assigning a different chain-identifier parameter to each of the plurality of CMCs, wherein said assigning comprises using a unique ID of each CMC to individually select each one of the plurality of CMCs when assigning the respective different chain-identifier parameter, wherein the unique ID of each CMC is received by the BMU in response to the BMU being configured to send, in parallel to the CMCs using the predetermined default value, one or more request messages requesting that they report their unique IDs to the BMU.

## Description

### Field

The present disclosure relates to a battery management unit. It also relates to a battery management unit for managing a battery pack in combination with a plurality of cell monitoring circuits that are associated with battery cells or groups of battery cells that form at least part of the battery pack. It also relates to a plurality of cell monitoring circuits with which the BMU communicates; a system comprising the battery management unit and a plurality of cell monitoring circuits and an associated method.

### Background

A battery pack typically comprises a plurality of battery cells or groups of cells, such as battery modules. A Cell Monitoring Circuit, which may include a Battery Cell Controller, is configured to monitor each battery cell or each group of battery cells. A battery management unit or BMU is configured to communicate with a plurality of CMCs. Providing an effective way for the BMU to communicate with the CMCs is a challenge.

### Summary

According to a first aspect of the present disclosure there is provided a battery management unit, BMU, configured to communicate with a plurality of cell monitoring circuits, each cell monitoring circuit, CMC, configured to provide for monitoring of one or more battery cells and to store a chain-identifier parameter initially comprising a predetermined default value, and wherein the battery management unit is configured to communicate with the plurality of cell monitoring circuits in parallel, wherein the battery management unit is configured to perform a chain-identifier parameter assignment procedure comprising assigning a different chain-identifier parameter to each of the plurality of CMCs, wherein said assigning comprises using a unique ID of each CMC to individually select each one of the plurality of CMCs when assigning the respective different chain-identifier parameter, wherein the unique ID of each CMC is received by the BMU in response to the BMU being configured to send, in parallel to the CMCs using the predetermined default value, one or more request messages requesting that they report their unique IDs to the BMU.

In one or more embodiments, the BMU, subsequent to said chain-identifier parameter assignment procedure, is configured to one or both of:
a) address a message to a particular one of the plurality of CMCs based on the assigned chain-identifier parameter;
b) receive a message from the CMCs, wherein a source of the message is identified by the message containing the assigned chain-identifier parameter.

In one or more embodiments, the BMU is configured to send, in parallel to the CMCs using the predetermined default value, a first request message, prior to assigning of the different chain identifier parameters and at least a second request message after assigning at least one of the different chain identifier parameters, wherein the second request message includes the predetermined default value such that it is configured to processed by the CMCs that still have the chain-identifier parameter set to the predetermined default value and ignored by the at least one CMC that has been assigned one of the different chain identifier parameters.

In one or more embodiments, the chain-identifier parameter assignment procedure comprises:
transmitting a first request message, of the one or more request messages, in parallel to the plurality of cell monitoring circuits, the first request message including at least:
   (i) a chain-identifier value set to the predetermined default value, the chain-identifier value defining which of the CMCs the first request is for, wherein only CMCs having a chain-identifier parameter that matches the chain-identifier value are configured to respond to the first request; and
   (ii) a request for the CMCs to respond with their unique ID;
receiving, from each of the plurality of CMCs having a chain-identifier parameter that matches the chain-identifier value, a second message containing the unique ID of that CMC;
selecting a first one of the received unique IDs and thereby a first one of the CMCs;
transmitting a third message in parallel to the plurality of CMCs, the third message including at least:
   (i) an indication that the third message is intended for the CMC having the selected first one of the received unique IDs;
   (ii) a request that the CMC having the selected first one of the received unique IDs changes their chain-identifier parameter to a first assigned value determined by the BMU;
performing a further assignment procedure, for each of a remainder of the plurality of CMCs, comprising selecting a different one of the received unique IDs to one previously selected during the chain-identifier parameter assignment procedure and thereby selecting a different one of the CMCs; transmitting a further message in parallel to the plurality of CMCs, the further message including at least:
   (i) an indication that the further message is intended for the different one of the CMCs having the selected different one of the received unique IDs; and
   (ii) a request that the CMC having the selected different one of the received unique IDs changes their chain-identifier parameter to a further assigned value determined by the BMU, the further assigned value being different to the first assigned value and any other further assigned value used during the further assignment procedure.

In one or more embodiments, said selecting the first one of the received unique IDs comprises selecting the received unique ID corresponding to the second message that is first received by the BMU.

In one or more embodiments, the further assignment procedure comprises transmitting a further first request message prior to the selecting of the different one of the received unique IDs to one previously selected during the chain-identifier parameter assignment procedure.

In one or more embodiments, the further first request message is sent each time prior to the selecting of the different one of the received unique IDs to one previously selected during the chain-identifier parameter assignment procedure.

In one or more embodiments, the further assigned value is determined by the BMU incrementing the first assigned value and, subsequently, each further assigned value each time the BMU requests a respective CMC to change its chain-identifier parameter.

In one or more embodiments, the BMU is configured to, in the event that the second message is not successfully received after a predetermined maximum delay period, re-transmit the first message.

According to a second aspect of the disclosure we provide a cell monitoring circuit, CMC, configured to communicate with a battery management unit, BMU, along with a plurality of other CMCs, each CMC comprising an integrated circuit configured to provide for monitoring of one or more battery cells and store a chain-identifier parameter initially comprising a predetermined default value, wherein the CMC is configured to, in response to a first message from the BMU, determine if the chain-identifier parameter indicated in the message matches the chain-identifier parameter of the CMC and, if there is a match, process the first message and, if there is not a match, ignore the message;
wherein the integrated circuit of the CMC further comprises a unique ID and the CMC, when processing said first message, is configured to report its unique ID in a second message to the BMU in response to the first message that requests reporting of the unique ID.

In one or more embodiments, the integrated circuit of the CMC is configured to transmit the second message after expiry of a randomly set delay period.

In one or more embodiments, the integrated circuit is configured to receive a third message or a further message in parallel to the plurality of CMCs, the third message or further message including at least:
(i) an indication that the third message or further message is intended for the CMC having a specified unique ID;
(ii) a request that the CMC having the specified unique ID changes their chain-identifier parameter to a first or further assigned value determined by the BMU;
wherein the CMC is configured to determine, in response to the third message or further message from the BMU, determine if the unique ID indicated in the message matches the unique ID of the integrated circuit of the CMC and, if there is a match, process the third or further message by changing the chain-identifier parameter to the first or further assigned value stated in the third or further message and, if there is not a match, ignore the message.

According to an aspect of the disclosure we provide a system comprising:
a BMU of the first aspect; and
a plurality of CMCs of the second aspect.

In one or more embodiments, the system further comprises a battery pack comprising one or both of a plurality of battery cells and a plurality of groups of battery cells, wherein the plurality of CMCs are each associated with a respective one of the plurality of battery cells and the plurality of groups of battery cells.

According to an aspect of the disclosure we provide a method for a battery management unit, BMU, for assigning a chain-identifier parameter, wherein the BMU is configured to communicate with a plurality of cell monitoring circuits, each cell monitoring circuit, CMC, configured to provide for monitoring of one or more battery cells and to store a respective chain-identifier parameter initially comprising a predetermined default value, and wherein the battery management unit is configured to communicate with the plurality of cell monitoring circuits in parallel, wherein the battery management unit is configured to perform a chain-identifier parameter assignment procedure comprising:
sending, in parallel to the CMCs using the predetermined default value, one or more request messages requesting that the CMCs report a unique ID associated with each CMC to the BMU;
receiving the unique ID of each CMC by the BMU;
assigning a different chain-identifier parameter to each of the plurality of CMCs, wherein said assigning comprises using the unique ID of each CMC to individually select each one of the plurality of CMCs when assigning the respective different chain-identifier parameter.

In one or more embodiments, the method comprises the BMU, subsequent to said chain-identifier parameter assignment procedure, addressing a message to a particular one of the plurality of CMCs based on the assigned chain-identifier parameter.

In one or more embodiments, the method comprises the BMU, subsequent to said chain-identifier parameter assignment procedure, receiving a message from the CMCs, wherein a source of the message is identified by the message containing the assigned chain-identifier parameter.

In one or more embodiments, the method comprises the BMU sending, in parallel to the CMCs using the predetermined default value, a first request message, prior to assigning of the different chain identifier parameters and at least a second request message after assigning at least one of the different chain identifier parameters, wherein the second request message includes the predetermined default value such that it is configured to processed by the CMCs that still have the chain-identifier parameter set to the predetermined default value and ignored by the at least one CMC that has been assigned one of the different chain identifier parameters.

In one or more embodiments, the method comprises sending a plurality of second request messages each time after assigning one or more of the different chain identifier parameters until the plurality of CMCs have been assigned.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example of a battery management unit communicably coupled with a plurality of Cell Monitoring Circuits in a series connected network topology;
Figure 2 shows an example embodiment of the disclosure comprising a system including a battery management unit communicably coupled with a plurality of Cell Monitoring Circuits in a parallel arranged communication network;
Figure 3 shows an example flowchart illustrating the operation of the battery management unit of figure 2;
Figure 4 shows a first example flowchart illustrating the operation of the Cell Monitoring Circuits of figure 2; and
Figure 5 shows a second example flowchart illustrating the operation of the Cell Monitoring Circuits of figure 2.

### Detailed Description

In a fast growing market environment, battery management systems are constantly evolving pushed by the need for more energy density, higher reliability and higher levels of safety. This is leading to new features that require high performance communication systems, such as communication systems having high synchronicity.

For example, a communication system may be required to allow for communication between the various "slaves" or cell monitoring circuits that are performing measurements (e.g. Electro Chemical Spectroscopy measurements) and a battery management unit. In other examples, the communication system may be required to provide for reconfigurable batteries.

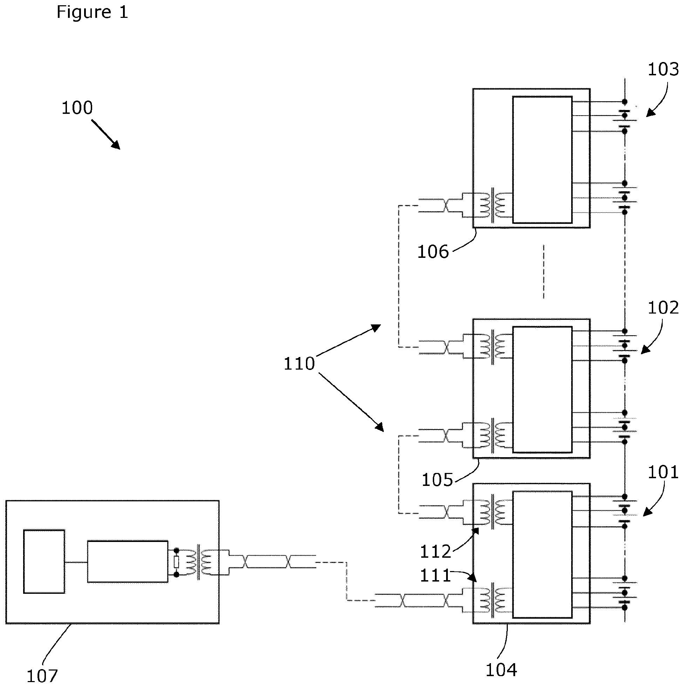

Figure 1 shows a system 100 including a battery pack and a communication system.

A battery pack typically comprises several modules, groups of battery cells 101, 102, 103, or individual cells that are each monitored by a Cell Monitoring Circuit (CMC) 104, 105, 106. Typically, a master unit, generally referred to as a Battery Management Unit (BMU) 107, communicates with the "slave" CMCs that are connected in "a daisy chain fashion" comprising a serially connected chain. The communication protocols in use typically do not include collision management.

It is generally a requirement that for manufacturability reasons that all the CMCs 104, 105, 106 are fully identical and therefore do not include an identifier that can identify their location within the serially connected chain. Therefore a daisy chain initialization process is needed to allow identification of all the nodes within the chain (so called "enumeration"). Each node should have a unique chain identifier ID (sometimes known as a chain identifier or CID) at the end of the enumeration procedure. The attribution of this CID is managed by the BMU at system 100 power-on or after any reset event.

For communication systems that comprise a serially connected chain, the enumeration procedure can be achieved by the BMU requesting that a non-enumerated node does not propagate the messages sent by the BMU that achieve enumeration to the following node in the daisy chain. Thus, one by one, the nodes can be enumerated and thereby assigned a CID. This auto-enumeration procedure can only be achieved with a daisy chain with a series topology as shown in Figure 1.

However, the serially connected chain communication wiring 110 topology presents some limitations. For example, it is known for battery cell controllers, present within the CMC, or the CMC in general to feature a repeater function which repeats messages to the adjacent CMC in the chain. The use of repeaters has been found to add a delay in the message propagation to the next node. This delay can be around 1 µs per node and can also be prone to variation due to digital jitter. This delay can hinder accurate synchronized operation within the serial connected chain. In other examples, where the BCC does not have a repeater function, the BCC may include switches that are used to disconnect the rest of the chain when the CMC is not enumerated and to terminate the chain to avoid reflection. However, the resistance of the switches in series and the insertion loss of the transformers 111, 112 contribute to the attenuation of the signals at each node, which accumulates along the serially connected chain. This limits the number of nodes that can be connected on a single daisy chain to around ten to fifteen depending on various parameters such as signal strength, wiring cable length and quality. In applications that require low node to node latency and long daisy chains, a serially connected chain topology is sub-optimal.

Thus, a parallel connected communication network between the CMCs may be preferred. However, as already mentioned, in many examples, there is an inability to effectively enumerate CMCs when they are arranged in a parallel communication topology.

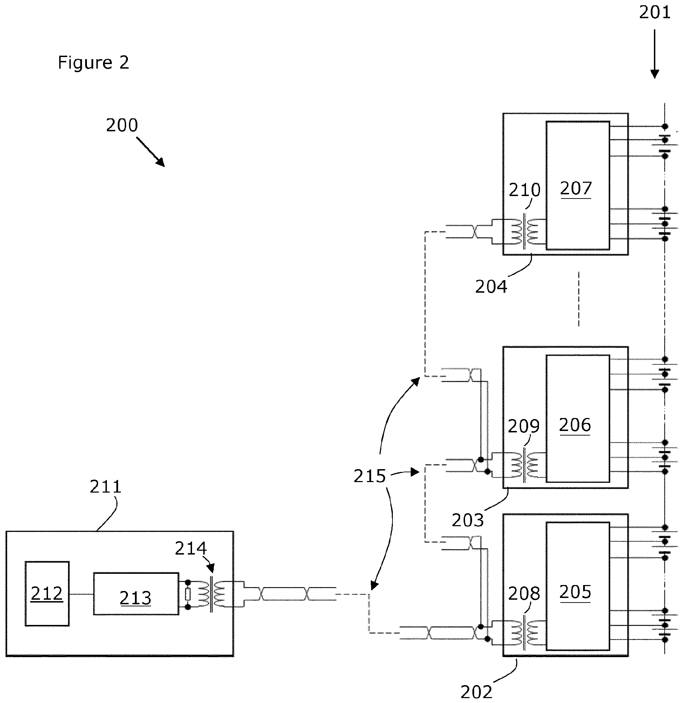

The present embodiments of the disclosure relate to a BMU that is configured to communicate with the CMCs by way of a parallel arranged communication network, as shown in Figure 2. In a parallel arranged communication network a message sent by the BMU is conveyed to all CMCs coupled to the parallel arranged communication network without the need for relaying of the message along a chain of CMCs by actions of the CMCs.

Figure 2 shows a system 200 comprising a plurality of battery cells 201 wherein respective groups of those battery cells 201 are monitored by a plurality of cell monitoring circuits or CMCs 202, 203, 204. Each CMC 202, 203, 204 may include one or more battery cell controllers 205, 206, 207. The CMCs 202, 203, 204 in the present example are each coupled to the parallel arranged communication network 215 by a transformer 208, 209, 210, although other galvanic isolation may be provided. The parallel arranged communication network is provided by a twisted pair of wires with parallel branches to couple to the transformers 208, 209, 210 of each CMC.

The system 200 includes a battery management unit, BMU, 211 configured to communicate with the plurality of cell monitoring circuits 202, 203, 204 via the parallel arranged communication network 215. The BMU 211 may comprise a microcontroller 212 and a physical layer block 213 that couples the microcontroller 212 to the parallel arranged communication network wiring via a transformer 214 (or other galvanic isolation). Accordingly, the MCU 212 may send and/or receive messages to/from the CMCs via the parallel arranged communication network

As mentioned previously, each CMC 202, 203, 204 is configured to store a chain-identifier parameter (known as chain ID parameter), which is conventionally used to store the chain-identifier value assigned to the CMC by the BMU in a serially connected network. The chain ID parameter is typically, at least initially at power-on or after a system reset, set to a predetermined default value. The predetermined default value may comprise "zero" in some examples.

In the present example, the battery management unit 211 is configured to communicate with the plurality of CMCs 202, 203, 204 in parallel and is configured to, at least during an initialization period such as power-on or after a reset, perform a chain-identifier parameter assignment procedure which will be described below.

The chain-identifier parameter assignment procedure comprises assigning a different chain-identifier parameter to each of the plurality of CMCs 204, 205, 206. Thus, each CMC coupled to the parallel arranged communication network is given a different chain ID assigned by the BMU, which provides for what is known in the art as enumeration of the CMCs. The assigning is achieved by using a unique ID of each CMC to individually select each one of the plurality of CMCs. Thus, the unique ID is used to ensure the BMU 211 is instructing a single CMC 202, 203, 204 when assigning the respective different chain-identifier parameter.

The unique ID may be a unique ID of an integrated circuit of the CMC, such as the integrated circuit 205-207 that provides the battery cell controller (BCC) functionality. It is known that many integrated circuits have a unique ID (UID) that is typically spread over several registers (e.g. 2 to 3) and IC manufacturers typically make sure that it is unique in a production span of over 10 years. Thus, it is has been found that the uniqueness of each integrated circuit's unique ID can be used to select a single CMC and thereby uniquely assign a chain identifier parameter in a parallel arranged communication network.

The unique ID of each CMC 202, 203, 204 is received by the BMU 211 in response to the BMU 211 being configured to send, in parallel to the CMCs using the predetermined default value, one or more request messages requesting that the CMCs report their unique IDs to the BMU 211. Thus, the BMU may be configured to send one or more request messages over the parallel communication network that specify the predetermined default value and will therefore be processed by CMCs having their chain-identifier parameter set to the predetermined default value (and not by those that don't have their chain-identifier parameter set to the predetermined default value). It may be standard functionality of a CMC 202, 203, 204 to interpret the request message and in response, read from the one or more registers that store the unique ID, generate a reply message containing the unique ID, and transmit the reply message to the BMU 211. These actions of the CMC will be described in more detail later.

The assignment of the different chain-identifier parameters to each of the CMCs makes them individually addressable thereby improving the performance of the parallel connected communication network.

Thus, the BMU, subsequent to the chain-identifier parameter assignment procedure, may be configured to address future messages to a particular one of the plurality of CMCs based on the assigned chain-identifier parameter. Alternatively or in addition, the BMU 211 may be configured to receive a message from the CMCs, wherein a source of the message is identified by the message containing the assigned chain-identifier parameter.

The CMCs 202, 203, 204 may be configured to, prior to said transmission of the reply message to the BMU 211, generate a random timer value termed t_{delay} and start a delay counter set to t_{delay}. Each CMC may be configured to wait until the delay counter has reached its t_{delay} value before the transmission of the reply message. There may be a maximum delay period and during such maximum delay period, if a reply message is received by the BMU 211 it can then assign the chain-identifier parameter using the unique ID contained in the reply message such that the assignment applies to one of the CMCs. In some examples, the BMU 211 may be configured to receive the first reply message (e.g. from the CMC that generated the shortest t_{delay}) and then stop processing any later-received reply messages. In other examples, the BMU 211 may be configured to collate a plurality of unique IDs from a corresponding plurality of received reply messages before assigning the different chain-identifier parameters using the unique IDs received in each of those reply messages to individually select each one of the plurality of CMCs in turn.

It will be appreciated that without collision management, it is a possibility that the reply messages from the plurality of CMCs 202, 203, 204 are transmitted at the same time and therefore may become corrupted on the parallel arranged communication network. Therefore, the BMU 211 may be configured to send a plurality of request messages in one or more examples. Given that the t_{delay} is generated randomly, sending a plurality of request message may improve the chance of successfully receiving the reply messages from all of the CMCs over time (i.e. successive request messages). It has also been recognised that only the CMCs having their chain identifier parameters set to the default value will respond to the plurality of request messages. Accordingly, the BMU 107 may be configured to send a request message after each assignment (or a predetermined number of assignments) of a different chain identifier parameter. In this way, the chance of a collision reduces as the number of CMCs responding to the request messages also reduces as the CMCs are assigned a different chain identifier parameter to the predetermined default value.

Thus, in general terms, the BMU 211 is configured to send, in parallel to the CMCs 202-204 using the predetermined default value, a first request message, prior to assigning of the different chain identifier parameter to say CMC 202 as an illustrative example. The CMCs 202-204 will therefore respond, with some or all of the reply messages successfully being received by the BMU 211. The BMU 211 may be configured to send at least a second request message after assigning the different chain identifier parameter to CMC 202, wherein the second request message includes the predetermined default value such that it is configured to be processed by the CMCs that still have the chain-identifier parameter set to the predetermined default value, namely CMCs 203 and 204 in the present example. The CMC 202 has been assigned a chain-identifier parameter other than the predetermined default value different and may therefore ignore second request message.

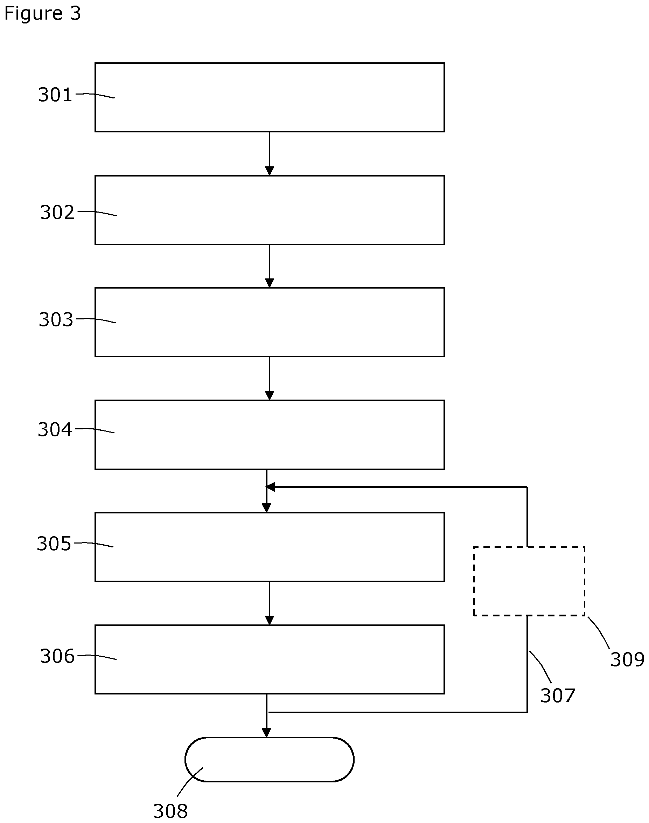

We will now describe the chain-identifier parameter assignment procedure in more detail with reference to the example flow chart of Figure 3.

The chain-identifier parameter assignment procedure comprises:
transmitting 301 a first request message, of the one or more request messages, in parallel to the plurality of cell monitoring circuits 202-204, the first request message including at least:
(i) a chain-identifier value set to the predetermined default value, and
(ii) a request for the CMCs to respond with their unique ID.

As mentioned above, the chain-identifier value in the first request message defines which of the CMCs the first request is for. Thus, only the CMCs 202-204 having a chain-identifier parameter that matches the chain-identifier value are configured to respond to the first request. Thus, initially, it is expected that the first request message will be processed and responded to by all of the CMCs 202-204 because the default value is used and, initially, all CMCs have the default value for their chain-identifier parameter.

The BMU 211 is then configured to receive 302, from each of the plurality of CMCs having a chain-identifier parameter that matches the chain-identifier value, a second message containing the unique ID of that CMC.

In the present example, the BMU is configured to act upon the first received second message. However, in other examples, the BMU 211 may receive multiple second messages.

The BMU 211 is then configured to select 303 a first one of the received unique IDs (that were reported in the second messages). In selecting a received unique ID, the BMU 211 is effectively selecting a first one of the CMCs, say CMC 202 for example.

The BMU 211 is then configured to transmit 304 a third message in parallel to the plurality of CMCs, the third message including at least:
(i) an indication that the third message is intended for the CMC having the selected first one of the received unique IDs;
(ii) a request that the CMC having the selected first one of the received unique IDs changes their chain-identifier parameter to a first assigned value determined by the BMU.

Thus, if the predetermined default value for the chain-identifier parameter is zero, the third request may instruct CMC 202 to change their chain-identifier parameter to "1".

The BMU 211 is then configured to perform a further assignment procedure. In effect, the further assignment procedure successively moves through the other unique IDs in order to assign a different chain-identifier parameter to each of the remaining CMCs 203 and 204.

Thus, for each of a remainder of the plurality of CMCs, namely CMCs 203, 204, the BMU 211 is configured to select 305 a different one of the received unique IDs to one previously selected during the chain-identifier parameter assignment procedure and thereby selecting a different one of the CMCs, say CMC 203 for example.

Then, the BMU 211 is configured to transmit 306 a further message in parallel to the plurality of CMCs, the further message including at least:
(i) an indication that the further message is intended for the different one of the CMCs (CMC 203 in this example) having the selected different one of the received unique IDs; and
(ii) a request that the CMC 203 having the selected different one of the received unique IDs changes their chain-identifier parameter to a further assigned value determined by the BMU, the further assigned value being different to the first assigned value and any other further assigned value used during the further assignment procedure.

The further message may instruct CMC 203 to change their chain-identifier parameter to "2". Thus, the BMU 211 may determine the further assigned value by incrementing the previously assigned value.

The BMU is then configured to repeat 307 the further assignment procedure for the remaining CMCs that have the predetermined default value of zero, which in this example is CMC 204.

Thus, the BMU 211 is configured to select 305 a different one of the received unique IDs to one previously selected during the chain-identifier parameter assignment procedure and thereby selecting a different one of the CMCs, which is the last remaining CMC 204 in this example.

Then, the BMU 211 is configured to transmit 306 another further message in parallel to the plurality of CMCs, the further message including at least:
(i) an indication that the further message is intended for the different one of the CMCs (CMC 204 in this iteration of the further assignment procedure) having the selected different one of the received unique IDs; and
(ii) a request that the CMC 204 having the selected different one of the received unique IDs changes their chain-identifier parameter to a further assigned value determined by the BMU, the further assigned value being different to the first assigned value and any other further assigned value used during the further assignment procedure.

The further message may instruct CMC 204 to change their chain-identifier parameter to "3" (incremented from "2", which was assigned in the previous iteration).

In one or more examples, the further messages described above also include a chain-identifier parameter value set to the predetermined default value.

When all of the CMCs have been assigned a chain-identifier parameter the BMU 211 may be configured to end 308 the chain-identifier parameter assignment procedure. The end may be determined by receiving no responses to the transmission of a first message.

The further assignment procedure may comprises the BMU 211 being configured to transmit 309 a further first request message (and receive the remaining unique IDs in second messages for the CMCs still having the predetermined default value for their chain-identifier parameter) prior to the selecting 305 of the different one of the received unique IDs to one previously selected during the chain-identifier parameter assignment procedure. Thus, the selecting step 305 may comprise selecting one of the unique IDs received in response to the transmitting 309 of the most recent further first request message.

In the present example, the BMU 211 is configured to transmit 309 the further first request message each time prior to the selecting 305 of the different one of the received unique IDs to one previously selected during the chain-identifier parameter assignment procedure. In other examples, multiple unique IDs may be collated from a plurality of received second message and therefore transmitting 309 the further first request message each time may not be necessary.

Given the lack of collision management, the BMU 211 may be configured to, in the event that the second message is not successfully received after a predetermined maximum delay period, re-transmit the first message. Retransmitting the first message (or further first message) will prompt the CMCs to generate a different T_{delay} and therefore a collision may not occur the next time.

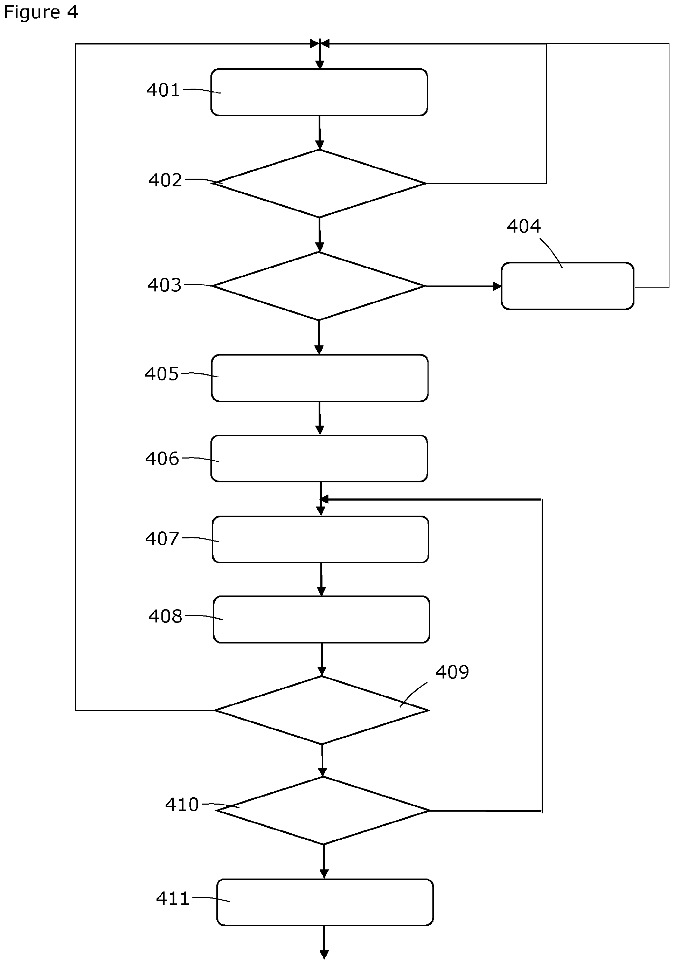

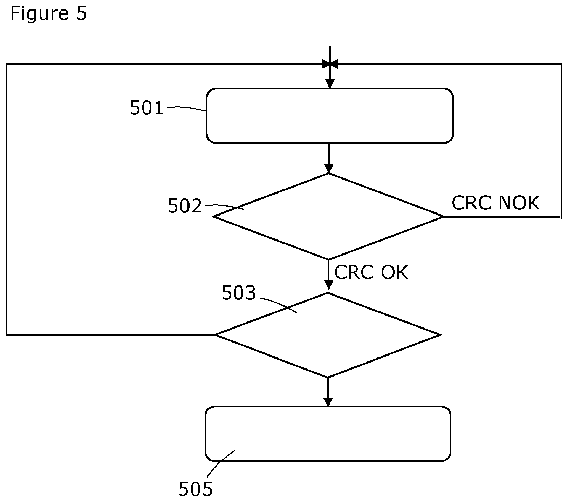

We will now describe the chain-identifier parameter assignment procedure from the point of view of any one of the CMCs 202-204 with reference to Figure 4 and Figure 5.

Thus, to restate the configuration of the components, each CMC 202-204 is configured to communicate with the battery management unit, BMU 211, along with the plurality of other CMCs.

Each CMC 202-204 comprises the integrated circuit 205-207, which may comprise the BCC, configured to provide for monitoring of one or more battery cells 201. The integrated circuit 205-207 or the CMC more generally may store the chain-identifier parameter initially comprising a predetermined default value.

The CMC 202-204 is configured to, in response to the first message or further first message, read 401 the unique ID from its registers. The reading of the registers may include an error check step 402, such as a cyclic redundancy check (CRC) verification process. If the CRC fails, the read 401 is performed again. If the CRC is ok, the CMC 202-204, in response to the first message from the BMU 211, is configured to determine 403 if the chain-identifier parameter indicated in the message matches the chain-identifier parameter of the CMC.

If there is not a match, the CMC ignores 404 the first message (or further first message) or since the node is already enumerated. If there is a match, the CMC is configured to continue to process the first message or further first message, which comprises the enumeration request.

Processing said first message or further first message comprises the CMC being configured to report its unique ID (read at 401) in a second message to the BMU in response to the first message that requests reporting of the unique ID.

This is achieved by the CMC generating a random T_{delay} at 405. A counter of IC 205 -207 is set to T_{delay} at 406. The CMC waits a further 1 µs at 407.

Step 408 shows the counter being decremented from T_{delay} (or incremented toward T_{delay} such that the delay period is counted out, whichever way the counter is implemented).

At step 409, if any bus activity is detected before the counter is equal to zero, then the CMC aborts the sending of the second message.

If no bus activity is detected when the counter is equal to zero 410, then the CMC transmits the content of the UID registers to the BMU in the second message 411.

Referring to Figure 5, the CMC 202-204 is configured to receive 501 the third message or the further message, wherein the third message or further message includes at least:
(i) an indication that the third message or further message is intended for the CMC having a specified unique ID;
(ii) a request that the CMC having the specified unique ID changes their chain-identifier parameter to a first or further assigned value determined by the BMU.

An error checking step may be performed at 502.

The CMC is further configured to determine if the unique ID indicated in the message matches the unique ID of the integrated circuit of the CMC at 503.

If there is a match, the CMC 202-204 is configured to process the third or further message by changing its chain-identifier parameter to the first or further assigned value stated in the third or further message at step 505.

If there is not a match of the unique ID, the CMC may ignore the message and the process performed by the CMC returns to step 501.

It will be appreciated that we also disclose the system 200 comprising the BMU 211 and the plurality of CMCs 202-204. The system 200 may be coupled to the battery pack 201 such that the CMCs are each associated with a respective one of the plurality of battery cells and the plurality of groups of battery cells.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A battery management unit, BMU, configured to communicate with a plurality of cell monitoring circuits, each cell monitoring circuit, CMC, configured to provide for monitoring of one or more battery cells and to store a chain-identifier parameter initially comprising a predetermined default value, and wherein the battery management unit is configured to communicate with the plurality of cell monitoring circuits in parallel, wherein the battery management unit is configured to perform a chain-identifier parameter assignment procedure comprising assigning a different chain-identifier parameter to each of the plurality of CMCs, wherein said assigning comprises using a unique ID of each CMC to individually select each one of the plurality of CMCs when assigning the respective different chain-identifier parameter, wherein the unique ID of each CMC is received by the BMU in response to the BMU being configured to send, in parallel to the CMCs using the predetermined default value, one or more request messages requesting that they report their unique IDs to the BMU.

2. The battery management unit of claim 1, wherein the BMU, subsequent to said chain-identifier parameter assignment procedure, is configured to one or both of:
a) address a message to a particular one of the plurality of CMCs based on the assigned chain-identifier parameter;
b) receive a message from the CMCs, wherein a source of the message is identified by the message containing the assigned chain-identifier parameter.

3. The battery management unit of claim 1 or claim 2, wherein the BMU is configured to send, in parallel to the CMCs using the predetermined default value, a first request message, prior to assigning of the different chain identifier parameters and at least a second request message after assigning at least one of the different chain identifier parameters, wherein the second request message includes the predetermined default value such that it is configured to processed by the CMCs that still have the chain-identifier parameter set to the predetermined default value and ignored by the at least one CMC that has been assigned one of the different chain identifier parameters.

4. The battery management unit of claim 1 or claim 2, wherein the chain-identifier parameter assignment procedure comprises:
transmitting a first request message, of the one or more request messages, in parallel to the plurality of cell monitoring circuits, the first request message including at least:
(i) a chain-identifier value set to the predetermined default value, the chain-identifier value defining which of the CMCs the first request is for, wherein only CMCs having a chain-identifier parameter that matches the chain-identifier value are configured to respond to the first request; and
(ii) a request for the CMCs to respond with their unique ID;
receiving, from each of the plurality of CMCs having a chain-identifier parameter that matches the chain-identifier value, a second message containing the unique ID of that CMC;
selecting a first one of the received unique IDs and thereby a first one of the CMCs;
transmitting a third message in parallel to the plurality of CMCs, the third message including at least:
(i) an indication that the third message is intended for the CMC having the selected first one of the received unique IDs;
(ii) a request that the CMC having the selected first one of the received unique IDs changes their chain-identifier parameter to a first assigned value determined by the BMU;
performing a further assignment procedure, for each of a remainder of the plurality of CMCs, comprising selecting a different one of the received unique IDs to one previously selected during the chain-identifier parameter assignment procedure and thereby selecting a different one of the CMCs; transmitting a further message in parallel to the plurality of CMCs, the further message including at least:
(i) an indication that the further message is intended for the different one of the CMCs having the selected different one of the received unique IDs; and
(ii) a request that the CMC having the selected different one of the received unique IDs changes their chain-identifier parameter to a further assigned value determined by the BMU, the further assigned value being different to the first assigned value and any other further assigned value used during the further assignment procedure.

5. The battery management unit of claim 4 wherein said selecting the first one of the received unique IDs comprises selecting the received unique ID corresponding to the second message that is first received by the BMU.

6. The battery management unit of claim 4 or claim 5, wherein the further assignment procedure comprises transmitting a further first request message prior to the selecting of the different one of the received unique IDs to one previously selected during the chain-identifier parameter assignment procedure.

7. The battery management unit of claim 6, wherein the further first request message is sent each time prior to the selecting of the different one of the received unique IDs to one previously selected during the chain-identifier parameter assignment procedure.

8. The battery management unit of any one of claims 4 to 7, wherein the further assigned value is determined by the BMU incrementing the first assigned value and, subsequently, each further assigned value each time the BMU requests a respective CMC to change its chain-identifier parameter.

9. The battery management unit of any one of claims 4 to 8, wherein the BMU is configured to, in the event that the second message is not successfully received after a predetermined maximum delay period, re-transmit the first message.

10. A cell monitoring circuit, CMC, configured to communicate with a battery management unit, BMU, along with a plurality of other CMCs, each CMC comprising an integrated circuit configured to provide for monitoring of one or more battery cells and store a chain-identifier parameter initially comprising a predetermined default value, wherein the CMC is configured to, in response to a first message from the BMU, determine if the chain-identifier parameter indicated in the message matches the chain-identifier parameter of the CMC and, if there is a match, process the first message and, if there is not a match, ignore the message;
wherein the integrated circuit of the CMC further comprises a unique ID and the CMC, when processing said first message, is configured to report its unique ID in a second message to the BMU in response to the first message that requests reporting of the unique ID.

11. The CMC of claim 10, wherein the integrated circuit of the CMC is configured to transmit the second message after expiry of a randomly set delay period.

12. The CMC of claim 10 or claim 11, wherein the integrated circuit is configured to receive a third message or a further message in parallel to the plurality of CMCs, the third message or further message including at least:
(i) an indication that the third message or further message is intended for the CMC having a specified unique ID;
(ii) a request that the CMC having the specified unique ID changes their chain-identifier parameter to a first or further assigned value determined by the BMU;
wherein the CMC is configured to determine, in response to the third message or further message from the BMU, determine if the unique ID indicated in the message matches the unique ID of the integrated circuit of the CMC and, if there is a match, process the third or further message by changing the chain-identifier parameter to the first or further assigned value stated in the third or further message and, if there is not a match, ignore the message.

13. A system comprising:
a BMU of any one of claims 1 to 9; and
a plurality of CMCs as defined in any one of claims 10 to 12.

14. The system of claim 13 further comprising a battery pack comprising one or both of a plurality of battery cells and a plurality of groups of battery cells, wherein the plurality of CMCs are each associated with a respective one of the plurality of battery cells and the plurality of groups of battery cells.

15. A method for a battery management unit, BMU, for assigning a chain-identifier parameter, wherein the BMU is configured to communicate with a plurality of cell monitoring circuits, each cell monitoring circuit, CMC, configured to provide for monitoring of one or more battery cells and to store a respective chain-identifier parameter initially comprising a predetermined default value, and wherein the battery management unit is configured to communicate with the plurality of cell monitoring circuits in parallel, wherein the battery management unit is configured to perform a chain-identifier parameter assignment procedure comprising:
sending, in parallel to the CMCs using the predetermined default value, one or more request messages requesting that the CMCs report a unique ID associated with each CMC to the BMU;
receiving the unique ID of each CMC by the BMU;
assigning a different chain-identifier parameter to each of the plurality of CMCs, wherein said assigning comprises using the unique ID of each CMC to individually select each one of the plurality of CMCs when assigning the respective different chain-identifier parameter.
